# EUROPEAN PATENT SPECIFICATION

(11) **EP 1 826 678 B1**
(45) Date of publication and mention of the grant of the patent: **31.10.2012**
(21) Application number: 06253900.2
(22) Date of filing: 26.07.2006
(51) Int. Cl.: G06F 13/28

(54) **Storage control apparatus, storage control method, computer product, and information processing apparatus**
Speichersteuerungsvorrichtung, Speichersteuerungsverfahren, Computerprodukt und Informationsverarbeitungsvorrichtung
Appareil de commande de stockage, procédé de commande de stockage, produit informatique et appareil de traitement d'informations

(30) Priority: 27.02.2006 JP 2006050374
(43) Date of publication of application: 29.08.2007
(73) Proprietor: Fujitsu Ltd., Kawasaki-shi, Kanagawa 211-8588 (JP)
(72) Inventor: Oka, Hiroyuki, Fujitsu Limited, Kawasaki-shi Kanagawa 211-8588 (JP); Nagatsuka, Masaaki, Fujitsu Limited, Kawasaki-shi Kanagawa 211-8588 (JP)
(74) Representative: Hitching, Peter Matthew

(56) References cited:
- EP-A2- 1 313 025
- WO-A-2006/057963
- US-A- 5 987 627
- US-A1- 2002 029 365

## Description

### BACKGROUND OF THE INVENTION

### 1. Field of the Invention

The present invention relates to a technology for storing reception data and reception status indicating a status of the reception data.

### 2. Description of the Related Art

Conventionally, when a computer system receives data, the computer system needs two areas, namely, a reception data area for storing received data on a storing unit like a main memory and a reception status area for storing a reception completion notice and the like. For example, even in the case of a data communication system disclosed in Japanese Patent Application Laid-Open No. 2001-147875, the two areas are required.

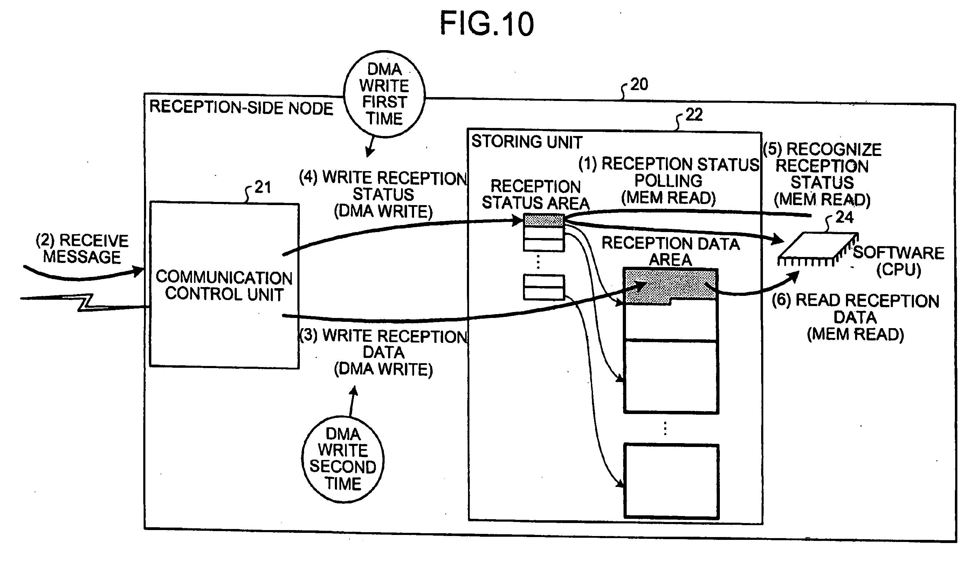

A flow of data that uses these two areas is specifically explained using Fig. 10. Software running on a central processing unit (CPU) or the like of a reception-side terminal apparatus checks the reception status area at fixed intervals to recognize that the data is written in the reception data area ((1) in Fig. 10). When a message (data) is received from the outside ((2) in Fig. 10), a communication control unit of the reception-side terminal apparatus writes the data received in the reception data area (DMA Write) ((3) in Fig. 10) and writes information indicating that the reception is completed in the reception status area (DMA Write) ((4) in Fig. 10).

When the CPU of the reception-side terminal apparatus recognizes that the data is written in the reception data area ((5) in Fig. 10), the CPU makes an access to the reception data area to read the data written ((6) in Fig. 10). In this way, the received data is read and used by the software and the like.

However, the conventional technology described above has a problem in that latency increases because the reception data and the reception status are stored in separate areas and write processing (DMA Write) is required to be performed twice.

Furthermore, when the software running on the CPU or the like reads the written data, the software needs to read the two areas, causing a performance of data read processing and the like to be deteriorated because the data and the status cannot be held in one cash line when data and a status are read out.

EP 1 313 025 discloses apparatus and methods for using direct memory access (DMA) to store and retrieve data and associated check information in fixed-size blocks on a data storage device. A DMA controller obtains check information from computer main memory rather than computing the check information internally. In accordance with one embodiment, the DMA controller implements additional registers to specify, for example, the location of check information in - computer main memory. The DMA controller itself carries out interleaving of data with its associated check information as it transfers information between main memory and the storage device.

US 5 987 627 discloses an apparatus called a DataPort for use in conjunction with a computer. The DataPort includes a private memory comprised of a high-speed, solid-state random access memory array. A public memory comprising a series of registers serves as an intermediary between the private memory array and a computer CPU local bus for memory access operations. The public memory includes staging registers which are used for conversion between the CPU local bus word size and the internal private memory word size as may be necessary, including pipelining as required. The DataPort also generates error correction codes (ECC) and stores the correction codes in the private memory, interleaved with data received from the CPU local bus, and checks the ECC codes to detect errors when data is read back out to the bus. The DataPort has the advantages of providing a high-speed, variable packet length, error-corrected access to a memory array at the CPU local bus operating speed, so that the device can be used with no wait states for improved throughput in a computer system.

### SUMMARY OF THE INVENTION

The invention is defined by the independent claims. Optional features are set out in the dependent claims.

It is an object of the present invention to at least solve the problems in the conventional technology.

A storage control apparatus according to one aspect of the present invention stores reception data and a reception status indicating a status of the reception data. The storage control apparatus includes a data storing unit that includes a plurality of areas divided in a predetermined range; and a data writing unit that writes, when the reception data is received from outside, the reception data and the reception status in one area of the data writing unit collectively with a single writing operation, in such a manner that the reception status is located at an end of the one area.

A storage control method according to another aspect of the present invention is for storing reception data and a reception status indicating a status of the reception data. The storage control method includes writing, when the reception data is received from outside, the reception data and the reception status in one area of the data writing unit collectively with a single writing operation, in such a manner that the reception status is located at an end of the one area.

A computer-readable recording medium according to still another aspect of the present invention stores a computer program for storing reception data and a reception status indicating a status of the reception data. The computer program causes a computer to execute writing, when the reception data is received from outside, the reception data and the reception status in one area of the data writing unit collectively with a single writing operation, in such a manner that the reception status is located at an end of the one area.

An information processing apparatus according to still another aspect of the present invention includes a communicating unit that controls transmission and reception of information; a storing unit that stores the information; and a writing unit that writes, when the information is received via the communicating unit, the information in the storing unit by attaching reception status information indicating a reception status of the information to an end of the information.

An information processing apparatus according to still another aspect of the present invention includes a communicating unit that controls transmission and reception of information; a storing unit that includes a plurality of areas for storing the information; and a writing unit that writes, when the information is received via the communicating unit, the information in one area of the storing unit, and at the same time, writes reception status information indicating a reception state of the received information at an end of the one area.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

Fig. 1 is a schematic for illustrating an overview and characteristics of a storage control apparatus according to a first embodiment of the present invention;
Fig. 2 is a block diagram for illustrating an internal configuration of a system employing the storage control apparatus according to the first embodiment;
Fig. 3 is a schematic for illustrating an example of treatment of transmission-command embedded data;
Fig. 4 is a flowchart of a processing procedure for a transmit-data creating process in a transmission-side terminal apparatus according to the first embodiment;
Fig. 5 is a flowchart of a processing procedure for a reception-data writing process in a reception-side terminal apparatus according to the first embodiment;
Fig. 6 is a schematic for illustrating a positional relation between application data, embedded data, and reception status in a reception data area;
Fig. 7 is a schematic for illustrating an overall configuration of a system employing a storage control apparatus according to a second embodiment of the present invention;
Fig. 8 is a block diagram of a computer system (transmission side) that executes a storage control program;
Fig. 9 is a block diagram of a computer system (reception side) that executes a storage control program; and
Fig. 10 is a schematic for illustrating a storage control apparatus according to a conventional technology.

### DETAILED DESCRIPTION OF THE PREFERRED EMBODIMENTS

Exemplary embodiments of the present invention are explained in detail below with reference to the accompanying drawings.

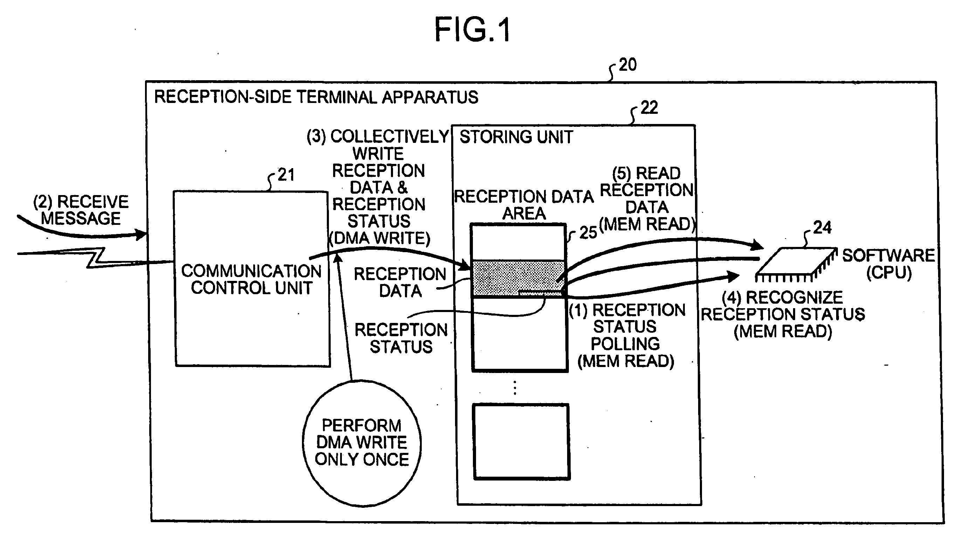

Fig. 1 is a schematic for illustrating an overview and characteristics of a storage control apparatus (reception-side terminal apparatus) according to a first embodiment of the present invention. A reception-side terminal apparatus 20 according to the first embodiment includes a communication control unit 21, a storing unit 22, and a software 24. A reception data area 25 in which reception data and a reception status are stored is provided in the storing unit 22. The reception status is written at the end of reception data corresponding to the reception status together with the reception status.

The reception-side terminal apparatus 20 writes reception data and a reception status indicating a status of the reception data together. The reception-side terminal apparatus 20 has main characteristics in that it is possible to reduce latency and it is possible to improve performance of data read processing and the like by a CPU and software.

In Fig. 1, the reception data area 25 includes plural areas sectioned in a predetermined range. The software 24 (which runs on the CPU; the same applies in the following description) of the reception-side terminal apparatus 20 checks the reception status in the reception data area 25, that is, the ends of the areas of the reception data area at fixed intervals to recognize that data is written in the reception data area 25 of the storing unit 22 ((1) in Fig. 1) .

When data is received from the outside, the communication control unit 21 of the reception-side terminal apparatus 20 creates a reception status and writes the reception data and the reception status in one area in the reception data area 25 collectively with a single writing operation such that the reception status is located at the end of the area ((2) to (3) in Fig. 1).

When the software 24 recognizes the reception status indicating that the data is written in the reception data area 25 ((4) in Fig. 1), the software 24 reads the reception data written in the reception data area 25 ((5) in Fig. 1).

In this way, the reception-side terminal apparatus 20 can read the reception data and the reception status by performing the writing once. As a result, as indicated by the main characteristics described above, it is possible to reduce latency. Further, only one area has to be read to read the reception data and the reception status. Thus, when the data and the status are read out, the data and the status can be held in one cache line. As a result, as indicated by the main characteristics described above, it is possible to improve performance of data read processing and the like by the software running on the CPU or the like.

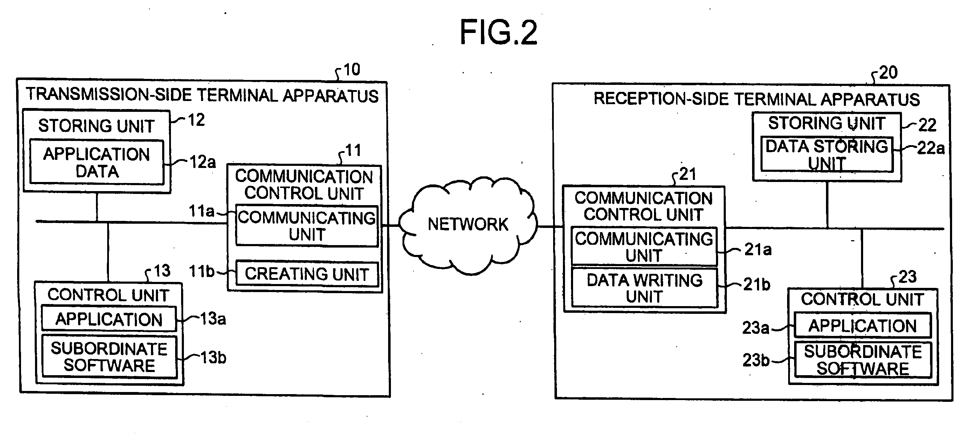

Fig. 2 is a block diagram for illustrating an internal configuration of a system employing the reception-side terminal apparatus 20 according to the first embodiment. As shown in the figure, a transmission-side terminal apparatus 10 includes a communication control unit 11, a storing unit 12, and a control unit 13 and is connected to the reception-side terminal apparatus 20 via a network.

The communication control unit 11 controls data exchanged between the transmission-side terminal apparatus 10 and the reception-side terminal apparatus 20 via the network, and creates data. In particular, as units closely related to the present invention, the communication control unit 11 includes a communicating unit 11a and a creating unit 11b.

The communicating unit 11a controls communication concerning various kinds of information exchanged between the transmission-side terminal apparatus 10 and the reception-side terminal apparatus 20 via the network. Specifically, the communicating unit 11a transmits transmit data created by the creating unit 11b described later to the reception-side terminal apparatus 20 via the network.

The creating unit 11b creates data to be transmitted to the reception-side terminal apparatus 20. Specifically, the creating unit 11b reads a memory area of the transmission-side terminal apparatus 10 based on parameters in a transmission command inputted from a subordinate software 13b and merges the memory area with embedded data in the transmission command to create a payload. Further, the creating unit 11b creates a header based on a size of user data and a size of the embedded data (the size of the embedded data is a fixed size). The creating unit 11b combines the payload and the header created to create transmit data.

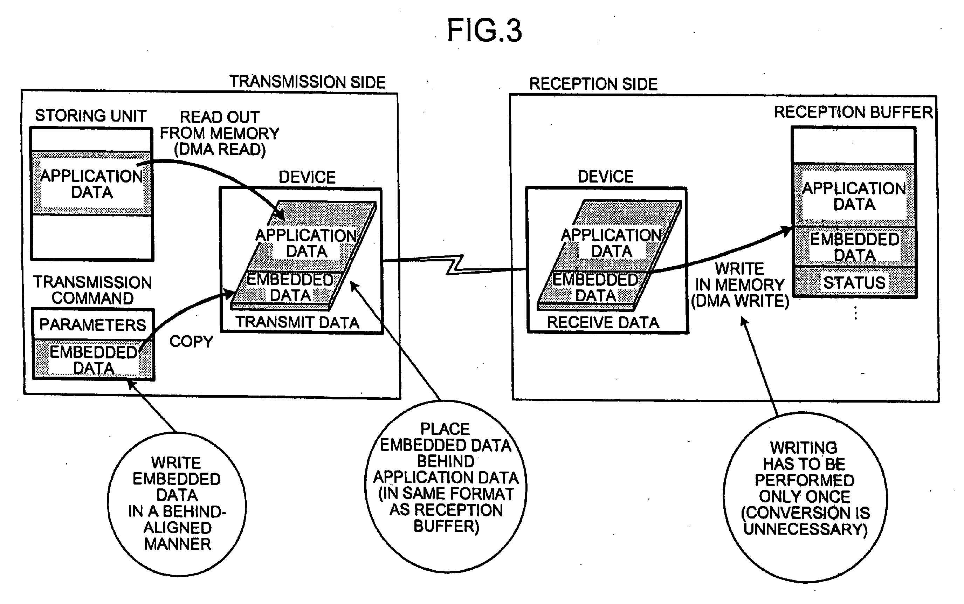

For example, as shown in Fig. 3, the creating unit 11b reads out application data from the storing unit 12 or the like based on the parameters in the transmission command. The creating unit 11b creates transmission data by placing the embedded data in the transmission command at an end of the transmission data and combining the embedded data with the application data. When the reception-side terminal apparatus 20 receives the transmission data created, the reception-side terminal apparatus 20 writes the application data, a reception status, and the embedded data collectively with a single writing operation such that the reception status is located at the end of one area of a reception buffer and the embedded data is located before the reception status.

The storing unit 12 is a storing means (memorizing means) for storing data and programs necessary for various kinds of processing by the control unit 13. In particular, as data closely related to the present invention, the storing unit 12 includes application data 12a as one of two kinds of data to be transmitted. Among the data, the application data 12a is read out by the creating unit 11b and transmitted to the reception-side terminal apparatus 20 as transmission data together with the embedded data.

The control unit 13 is a processing unit that has an internal memory for storing a control program like an Operating System (OS), programs defining various processing procedures, and required data and executes various kinds of processing according to the programs and the data. In particular, as programs closely related to the present invention, the control unit 13 includes an application (software) 13a and the subordinate software 13b.

The application 13a is software that executes processing for performing transfer request for data. As a specific example, the application 13a is executed by the control unit 13 according to instruction operation by a user to request the subordinate software 13b to transfer the application data 12a stored in the storing unit 12.

The subordinate software 13b receives a transfer request for data and transmits a transmission command to the communication control unit 11. As a specific example, when the subordinate software 13b receives a data transfer request from the application 13a, the subordinate software 13b creates a transmission command based on parameters (e.g., a starting address and a size) designated by the application 13a. The subordinate software 13b inputs the transmission command created to the communication control unit 11.

As shown in Fig. 2, the reception-side terminal apparatus 20 includes the communication control unit 21, the storing unit 22, and a control unit 23.

The communication control unit 21 receives data from the transmission-side terminal apparatus 10 via the network, creates a reception status from the reception data, and writes the reception data and the reception status. In particular, as units closely related to the present invention, the communication control unit 21 includes a communicating unit 21a and a data writing unit 21b. The data writing unit 21b corresponds to a "data writing unit" described in claims.

The communicating unit 21a receives data from the transmission-side terminal apparatus 10 and creates a reception status. As a specific example, as shown in Fig. 3, when the communicating unit 21a receives the transmission data created by placing the embedded data at the end of the transmission data and combining the embedded data with the application data, from the transmission-side terminal apparatus 10, the communicating unit 21a obtains a size of a payload (a sum of the application data and the embedded data) from a header of the data. The communicating unit 21a creates a reception status and calculates a writing start position in one area of a data storing unit 22a of the storing unit 22 (a size of the reception status is fixed). The reception status includes an update flag, presence or absence of an error, and a reception data size.

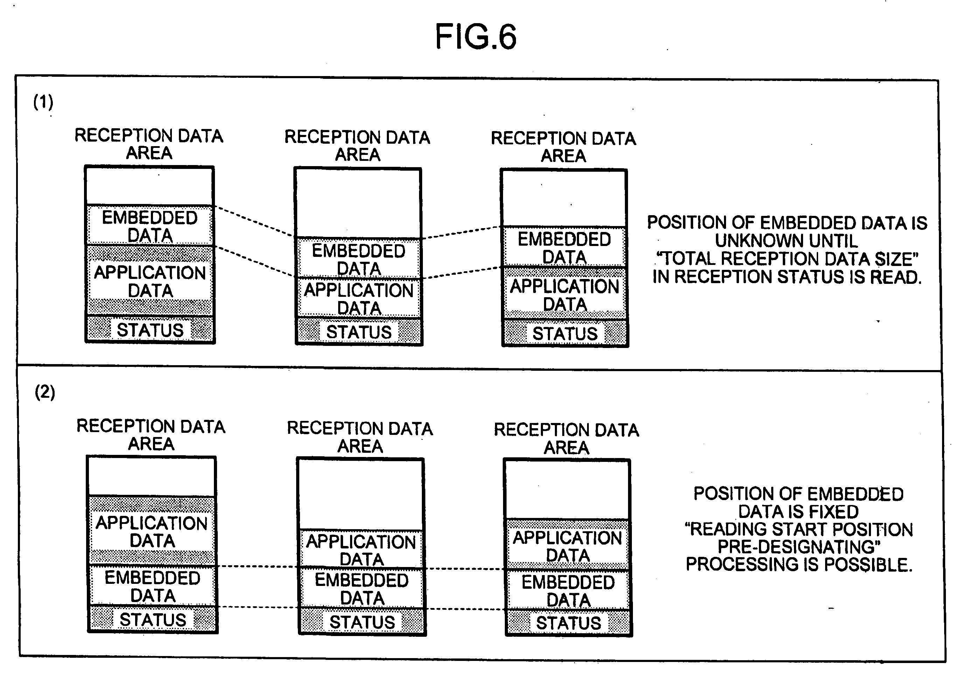

The data writing unit 21b writes two kinds of data and a reception status in one area of the data storing unit 22a collectively with a single writing operation such that the reception status is located at the end of the area and the two kinds of data are located right in front of the reception status. As a specific example, the data writing unit 21b writes reception data, a reception status, and embedded data in one area of the data storing unit 22a collectively with a single writing operation using a writing start position obtained from the communicating unit 21a such that the reception status is located at the end of the area and the embedded data is located right in front of the reception status (see Fig. 6).

The storing unit 22 is a storing means (memorizing means) for storing data and programs necessary for various kinds of processing by the control unit 23. In particular, as units closely related to the present invention, the storing unit 22 includes the data storing unit 22a. The data storing unit 22a is means that includes plural areas sectioned in a predetermined range and stores data and the like written by the data writing unit 21b. As a specific example, reception data, a reception status, and embedded data are written by the data writing unit 21b such that the reception status is located at the end of one area of the areas and the embedded data is located before the reception status.

The control unit 23 is a processing unit that has an internal memory for storing a control program such as an Operating System (OS), programs defining various processing procedures and the like, and required data and executes various kinds of processing according to the programs and the data. In particular, as applications and data closely related to the present invention, the control unit 23 includes an application 23a and a subordinate software 23b.

The application 23a is software that executes processing using the application data stored in the storing unit 22. As a specific example, the application 23a executes the subordinate software 23b and executes processing with reference to the application data stored in the data storing unit 22a of the storing unit 22.

The subordinate software 23b passes the reception data to the application 23a by referring to the reception status. As a specific example, the subordinate software 23b checks, with reference to the end of the area of the data storing unit 22a at fixed intervals, whether the reception status is written. When the subordinate software 23b confirms that the reception status is written, the subordinate software 23b reads the reception status, obtains sizes of the application data and the embedded data written in the data storing unit 22a, and reads the embedded data. Thereafter, the subordinate software 23b calculates a starting address (an offset) of the application data and passes the starting address obtained by the calculation to the application 23a.

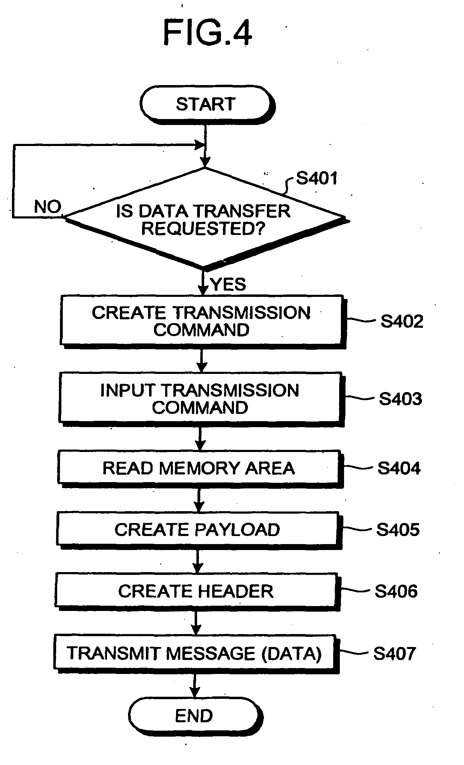

Fig. 4 is a flowchart of a processing procedure for a transmit-data creating process in the transmission-side terminal apparatus 10 according to the first embodiment.

When the subordinate software 13b of the control unit 13 receives a data transfer request from the application 13a ("Yes" at step S401), the subordinate software 13b creates a transmission command from parameters (e.g., a starting address and a size) designated by the application 13a (step S402). Subsequently, the subordinate software 13b inputs the transmission command created to the creating unit 11b of the communication control unit 11 (step S403).

The creating unit 11b reads the application data 12a of the storing unit 12 based on the parameters in the transmission command received (step S404) and combines the application data 12a read and embedded data in the transmission command to create a payload (step S405).

Thereafter, the creating unit 11b creates a header based on a size of the application data 12a to be transmitted and a size of the embedded data (step S406). The creating unit 11b combines the payload and the header to create a message (transmit data). The communicating unit 11a transmits the message (the transmission data) created to the reception-side terminal apparatus 20 (step 5407) .

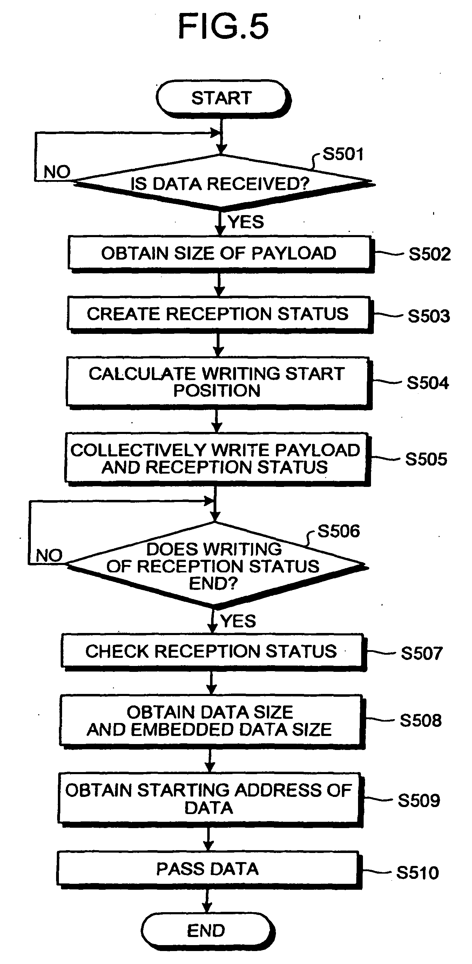

Fig. 5 is a flowchart of a processing procedure for a reception-data writing process in the reception-side terminal apparatus 20 according to the first embodiment.

When the communicating unit 21a receives data transmitted from the transmission-side terminal apparatus 10 ("Yes" at step S501), the communicating unit 21a obtains a payload (a sum of application data and embedded data) from a header of the data received (step S502). The communicating unit 21a creates a reception status (step S503) and calculates a writing start position in one area of the data storing unit 22a of the storing unit 22 (step S504).

The data writing unit 21b writes the payload (the reception data), the reception status, and the embedded data in one area of the data storing unit 22a collectively with a single writing operation such that the reception status is located at the end of the area and the embedded data is located before the reception status (step S505).

When the writing of the reception status ends ("Yes" at step S506), the subordinate software 23b checks the reception status at the end of the area (step S507) and obtains a size of the data written and a size of the embedded data (step S508). The subordinate software 23b reads the embedded data (step S509) and passes the embedded data to the application 23a. The subordinate software 23b calculates a starting address (an offset) of the data written in the data storing unit 22a and passes the data to the application 23a (step S510).

As described above, according to the first embodiment, the data storing unit 22a includes the areas sectioned in the predetermined range and, when the data storing unit 22a receives reception data from the outside, the data storing unit 22a writes the reception data and a reception status in one area of the data storing unit 22a collectively with a single writing operation such that the reception status is located at the end of the area With such a constitution, it is possible to write the reception data and the reception status by performing the writing once. As a result, it is possible to reduce latency. Further, only one area has to be read to read the reception data and the reception status. Therefore, when the data and the status are read out, the data and the status can be held in one cache line. As a result, it is possible to improve performance of data reading processing by software of the CPU or the like.

Furthermore, according to the first embodiment, the data writing unit 21b the reception data and the reception status are written in the area collectively with a single writing operation such that the reception data is placed before the reception status in the area. Thus, it is possible to use reading start position pre-designating processing. For example, it is possible to read the reception data designating an address in advance on the software side that uses the reception data. As a result, it is possible to reduce overhead.

Moreover, according to the first embodiment, the data writing unit 21b writes two kinds of data and the reception status in one area of the data storing unit 22a collectively with a single writing operation such that the reception status is located at the end of the area and the two kinds of data are located before the reception status. Thus, for example, when the reception data is formed by application data and embedded data indicating control information of software, the reception data, the reception status, and the embedded data are written in the area collectively with a single writing operation such that the reception status is located at the end of the area and the embedded data is located right in front of the reception status. Thus, the embedded data is written in a fixed position. As a result, the software is capable of using the reading start position pre-designating processing. Further, since the data is received in a format that is the same as a writing format, conversion processing for the reception data is unnecessary. As a result, it is possible to further reduce the overhead. The embedded data is written to be adjacent to the reception status. For example, when the data is read out by the software of the CPU or the like, it is more likely that the embedded data and the reception status can be held in the same cache line. Thus, it is possible to effectively use a cache.

As shown in (1) in Fig. 6, when a reception status, application data, and embedded data are written in a reception data area in this order, a position of the embedded data varies depending on a size of the application data. Thus, it is impossible to obtain the position of the embedded data until the reception status is read. On the other hand, as shown in (2) in Fig. 6, when a reception status, embedded data, and application data are written in a reception data area in this order, data sizes of the reception status and the embedded data are fixed and do not depend on a size of the application data. It is possible to use the reading start position pre-designating processing, for example, refer to the embedded data.

In the explanation of the first embodiment described above, the reception data is written in one area of the reception data area. However, the present invention is not limited to this scheme. The present invention may be used when written data is updated. Thus, in the following explanation, as a second embodiment of the present invention, data written in one area of a reception data area is updated.

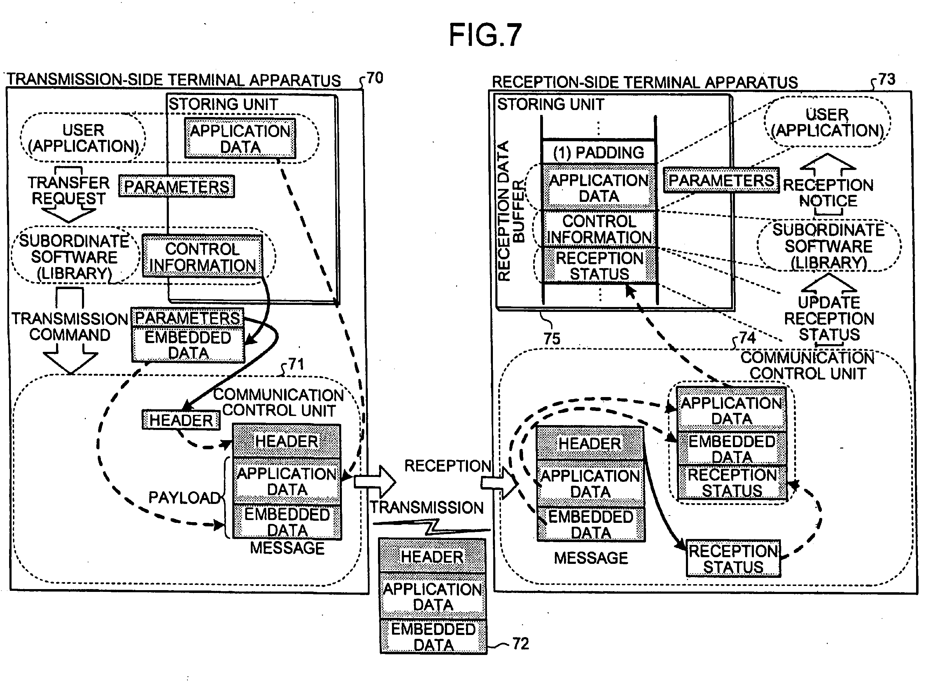

Fig. 7 is a schematic for illustrating an overall configuration of a system employing a storage control apparatus according to the second embodiment. A transmission-side terminal apparatus 70 includes a storing unit and a communication control unit 71. Operations of the transmission-side terminal apparatus 70 are controlled by a control unit (CPU) (not-shown). A storing unit 75 and a communication control unit 74 are provided in a reception-side terminal apparatus 73 as well. Operation control of the entire reception-side terminal apparatus 73 is managed by the control unit. The transmission-side terminal apparatus 70 and the reception-side terminal apparatus 73 are connected to each other via a network or the like.

As shown in Fig. 7, the communication control unit 71 of the transmission-side terminal apparatus 70 reads a memory area of the transmission-side terminal apparatus 70 based on parameters in a transmission command inputted from subordinate software and merges the memory area with embedded data in the transmission command to create a payload. Further, the communication control unit 71 creates a header based on a size of user data and a size of the embedded data. Then, the communication control unit 71 reads out application data from the storing unit based on the parameters in the transmission command. The communication control unit 71 places the embedded data in the transmission command at the end of transmission data 72 and combines the embedded data with the application data to create the transmission data 72 (a message).

Subsequently, the communication control unit 74 of the reception-side terminal apparatus 73 receives the transmission data 72 transmitted by the transmission-side terminal apparatus 70. The communication control unit 74 obtains a size of a payload (a sum of the application data and the embedded data) from a header of the transmission data 72. The communication control unit 74 creates a reception status and calculates a writing start position in one area of the data storing unit 22a of the storing unit 22.

Thereafter, the reception-side terminal apparatus 73 writes the application data, the embedded data, and the reception status in one area of a reception data buffer collectively with a single writing operation such that the reception status is located at the end of the area of the reception data buffer and two kinds of data (e.g., the application data and the embedded data) are located right in front of the reception status. The subordinate software reads out the reception status and passes the application data to an application.

When the communication control unit 74 of the reception-side terminal apparatus 73 updates data written in the storing unit 75, the communication control unit 74 aligns a writing start address of the reception data buffer with a cache line of a cache to which the data is read out ((1) in Fig. 7). Specifically, for example, to align the data with the cache line of the cache, the communication control unit 74 writes padding (garbage) at the head portion of data that is written such that the data has a size equal to a size of an area allocated to write reception data.

As described above, according to the second embodiment, when the reception data stored is updated, the communication control unit 74 sets a writing start address of the reception data to integer times as large as a memory alignment determined in advance or a block size determined in advance. Thus, for example, in an information processing apparatus (a computer) in which partial write (partial rewrite) for a block of a cache line size is late compared with rewrite of the entire block, it is possible to bring out maximum performance in a situation in which it is possible to update the reception data from a side just before (an upper address of) an area where the data should originally be written.

The examples of the present invention have been explained. However, the present invention may be practiced in various different forms other than the embodiments described above.

For example, when there is an error in reception data, an error flag can be written instead of a reception status. Consequently, when there is an error in the reception data, for example, when a CRC is attached at the end of the reception data to detect a bit error, the error flag is written instead of the reception status. Thus, writing of the reception data is completed when the reception status is written. It is possible to guarantee appropriateness of the written data. For example, writing of the data is started before the data is received to the end. Thus, it is possible to further reduce latency.

Among the processes by the transmission-side terminal apparatus (see Fig. 4) and the processes by the reception-side terminal apparatus (see Fig. 5), all or a part of the kinds of processing explained as being automatically performed may be manually performed. All or a part of the kinds of processing explained as manually performed may be automatically performed according to a publicly known method. Besides, it is possible to arbitrarily change the processing procedures, the control procedures, the specific names, and the information including various data and parameters (e.g., the reception data and the reception status) unless specifically noted otherwise.

The respective components of the transmission-side terminal apparatus and the reception-side terminal apparatus shown in Fig. 4 or Fig. 5 are functionally conceptual and are not always required to be physically constituted as shown in the figure. In other words, specific forms of distribution and integration of the components of the respective apparatuses, for example, integration and distribution of the communicating unit 11a and the creating unit 11b are not limited to those shown in the figure. It is possible to constitute all or a part of the components to be functionally or physically distributed and integrated in an arbitrary unit according to various loads, states of use, and the like. Moreover, all or an arbitrary part of the various processing functions performed in the transmission-side terminal apparatus and the reception-side terminal apparatus can be realized by a CPU and programs analyzed and executed by the CPU or can be realized as hardware according to the wired logic.

It is possible to realize the various kinds of processes explained in the embodiments by executing programs prepared in advance with a computer system like a personal computer or a work station.

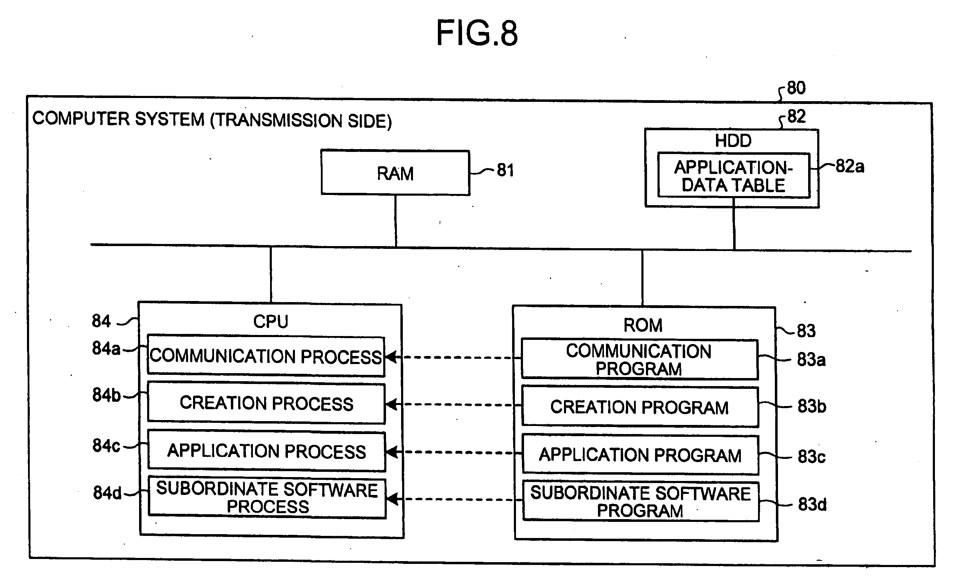

Fig. 8 is a block diagram of a computer system (transmission side) 80 that executes a storage control program. The computer system 80 includes a random access memory (RAM) 81, a hard disk drive (HDD) 82, a read only memory (ROM) 83, and a CPU 84. In the ROM 83, programs that display the same functions as the examples described above, that is, a communication program 83a, a creation program 83b, an application program 83c, and a subordinate software program 83d are stored in advance as shown in Fig. 8.

The CPU 84 reads out and executes the programs 83a to 83d. Consequently, as shown in Fig. 8, the CPU 84 functions as a communication process 84a, a creation process 84b, an application process 84c, and a subordinate software process 84d. The respective processes 84a to 84d correspond to the communicating unit 11a, the creating unit 11b, the application 13a, and the subordinate software 13b shown in Fig. 2.

An application-data table 82a used for the application process 84c and the like and transmitted to other computer systems via the network is provided in the HDD 82. The CPU 84 calls information stored in the application-data table 82a to the RAM 81 and executes various kinds of processing. The application-data table 82a corresponds to the application data 12a shown in Fig. 2.

The programs 83a to 83d do not always have to be stored in the ROM 83. For example, the programs 83a to 83d may be stored in, besides "portable physical media" like a Flexible Disk (FD), a CD-ROM, an MO disk, a DVD disk, a magneto-optical disk, and an IC card that are inserted in the computer system 80, "fixed physical media" like a hard disk (HD) provided on the inside or the outside of the computer system 80 and "other computer systems" connected to the computer system 80 via a public line, the Internet, a local area network (LAN), a wide area network (WAN), and the like. The computer system 80 may read out the programs from these media and execute the programs.

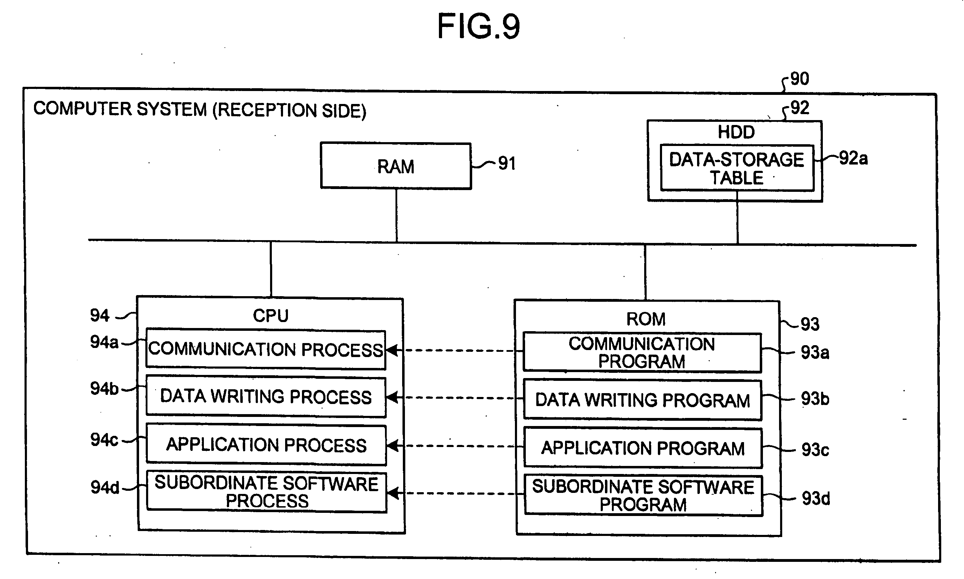

Fig. 9 is a block diagram of a computer system (reception side) 90 that executes a storage control program. The computer system 90 includes a RAM 91, an HDD 92, a ROM 93, and a CPU 94. In the ROM 93, programs that display the same functions as the examples described above, that is, a communication program 93a, a data writing program 93b, an application program 93c, and a subordinate software program 93d are stored in advance as shown in Fig. 9.

The CPU 94 reads out and executes the programs 93a to 93d. Consequently, as shown in Fig. 9, the CPU 94 functions as a communication process 94a, a data writing process 94b, an application process 94c, and a subordinate software process 94d. The respective processes 94a to 94d correspond to the communicating unit 21a, the data writing unit 21b, the application 23a, and the subordinate software 23b shown in Fig. 2.

A data-storage table 92a including plural areas sectioned in a predetermined range is provided in the HDD 92. The CPU 94 calls information stored in the data-storage table 92a to the RAM 91 and executes various kinds of processing. The data-storage table 92a corresponds to the data storing unit 22a shown in Fig. 2.

The programs 93a to 93d do not always have to be stored in the ROM 93. For example, the programs 93a to 93d may be stored in, besides "portable physical media" such as a Flexible Disk (FD), a compact disk-read only memory (CD-ROM), a magneto-optical (MO) disk, a digital versatile disk (DVD), and an integrated-circuit (IC) card that are inserted in the computer system 90, "fixed physical media" such as an HD provided on the inside or the outside of the computer system 90 and "other computer systems" connected to the computer system 90 via a public line, the Internet, a LAN, a WAN, and the like. The computer system 90 may read out the programs from these media and execute the programs.

According to an embodiment of the present invention, the data storing unit includes the areas sectioned in the predetermined range and the data writing unit writes, when reception data is received from the outside, the reception data and a reception status in one of the areas collectively with a single writing operation such that the reception status is located at the end of the area. Thus, it is possible to write the reception data and the reception status by performing the writing once. As a result, it is possible to reduce latency. Further, only one area has to be read to read the reception data and the reception status. Thus, when the data and the status are read out, the data and the status can be held in one cache line. As a result, it is possible to improve performance of data read processing and the like by software of a CPU or the like.

Furthermore, according to an embodiment of the present invention, the data writing unit writes the reception data and the reception status in the area collectively with a single writing operation such that the reception data is placed before the reception status in the area. Thus, it is possible to use reading start position pre-designating processing. For example, it is possible to read the reception data designating an address in advance on a software side that uses the reception data. As a result, it is possible to reduce overhead.

Moreover, according to an embodiment of the present invention, the data writing unit writes two kinds of data and the reception status in the area collectively with a single writing operation such that the reception status is located at the end of the area and the two kinds of data are located before the reception status. Thus, for example, when the reception data is formed by application data and embedded data indicating control information of software, the reception data, the reception status, and the embedded data are written in the area collectively with a single writing operation such that the reception status is located at the end of the area and the embedded data is located before the reception status. Thus, the embedded data is written in a fixed position. As a result, the software is capable of using the reading start position pre-designating processing. Further, since the data is received in a format that is the same as a writing format, conversion processing for the reception data is unnecessary. As a result, it is possible to further reduce the overhead. The embedded data is written to be adjacent to the reception status. For example, when the data is read out by the software of the CPU or the like, it is more likely that the embedded data and the reception status can be held in the same cache line. Thus, it is possible to effectively use a cache.

Furthermore, according to an embodiment of the present invention, when there is an error in the reception data, for example, when a CRC is attached at the end of the reception data to detect a bit error, the data writing unit writes an error flag instead of the reception status. Thus, writing of the reception data is completed when the reception status is written. It is possible to guarantee appropriateness of the written data. For example, writing of the data is started before the data is received to the end. Thus, it is possible to further reduce latency.

Moreover, according to an embodiment of the present invention, when the reception data stored is updated, the data updating unit sets a writing start address of the reception data to integer times as large as a memory alignment determined in advance or a block size determined in advance. Thus, for example, in an information processing apparatus (a computer) in which partial write (partial rewrite) for a block of a cache line size is late compared with rewrite of the entire block, it is possible to bring out maximum performance in a situation in which it is possible to update the reception data from a side just before (an upper address of) an area where the data should originally be written. As an example, in the case of a computer with a cache line size of 64 bytes, low order 6 bits (6th power of 2 = 64) of the writing start address (a byte address) is masked with 0 (forcibly set to 0). Although the invention has been described with respect to a specific embodiment for a complete and clear disclosure, the appended claims are not to be thus limited but are to be construed as embodying all modifications and alternative constructions that may occur to one skilled in the art that fairly fall within the basic teaching herein set forth.

## Claims

1. A storage control apparatus that communicates with a transmission-side terminal apparatus (10) and stores reception data and a reception status indicating a status of the reception data, the storage control apparatus comprising:
a data storing unit (22a) that includes a plurality of areas (25) divided in a predetermined range; and
a communicating unit (21a) that receives data from the transmission-side terminal apparatus and creates the reception status from the reception data;
**characterised by**
a data writing unit (21b) that writes, when the reception data is received from the transmission-side terminal apparatus, the reception data and the reception status in one of the plurality of the areas of the data storing unit collectively with a single writing operation, in such a manner that the reception status is written at the end of the reception data, and that the reception status is located at an end of the one of the plurality of areas; wherein
the reception status indicates that the reception data is written in the one of the plurality of areas.

2. The storage control apparatus according to claim 1, **characterized in that**
the reception data includes first data and second data, and
the data writing unit (21b) writes the first data, the second data, and the reception status in the one of the plurality of areas (25) collectively with a single writing operation, in such a manner that the reception status is written at the end of the reception data, and that the reception status is located at the end of the one area and the first data and the second data are located right in front of the reception status in order.

3. The storage control apparatus according to claim 2, **characterized in that**
the first data is embedded data indicating control information of a software, and
the second data is application data.

4. The storage control apparatus according to claims 1 and 2, **characterized in that**
when there is an error in the reception data, the data writing unit (21b) writes an error flag instead of the reception status.

5. The storage control apparatus according to claims 1, 2, and 4, **characterized by** further comprising:
a data updating unit (74) that sets, when updating the reception data stored in the data storing unit (22a), a writing start address of the reception data to integer multiple of a memory alignment determined in advance or a block size determined in advance.

6. A storage control method of communicating with a transmission-side terminal apparatus (10) and storing reception data and a reception status indicating a status of the reception data in a data storing unit (22a) that includes a plurality of areas (25) divided in a predetermined range, the storage control method comprising:
receiving data from the transmission-side terminal apparatus and creating the reception status from the reception data; and
writing, when the reception data is received from the transmission-side terminal apparatus, the reception data and the reception status in one of the plurality of areas of the data storing unit (22b) collectively with a single writing operation, in such a manner that the reception status is written at the end of the reception data, and that the reception status is located at an end of the one of the plurality of areas; wherein
the reception status indicates that the data is written in the one of the plurality of areas.

7. A computer-readable recording medium that stores a computer program, which, when executed on a computer, causes the computer to perform the method of claim 6.

8. An information processing apparatus comprising:
the storage control apparatus of claim 1; wherein
a communicating unit (21a) controls transmission and reception of information;
the data storing unit (22a) stores the information; and
the data writing unit (21b) writes, when the information is received via the communicating unit, the information in the data storing unit by attaching reception status information indicating a reception status of the information to an end of the information.

## Patentansprüche

1. Speichersteuervorrichtung, welche mit einer Übertragungsseiten-Terminalvorrichtung (10) kommuniziert und Empfangsdaten und einen Empfangsstatus, welcher ein Status der Empfangsdaten anzeigt, speichert, wobei die Speichersteuervorrichtung umfasst:
eine Datenspeichereinheit (22a), welche eine Vielzahl von Bereichen (25) beinhaltet, unterteilt in eine vorbestimmten Spanne; und
eine kommunizierende Einheit (21a), welche Daten von der Übertragungsseiten-Terminalvorrichtung empfängt und den Empfangsstatus aus den empfangenen Daten erzeugt; **gekennzeichnet durch**
eine Datenschreibeeinheit (21b), welche, wenn die Empfangsdaten von der Übertragungsseiten-Terminalvorrichtung empfangen werden, die Empfangsdaten und den Empfangsstatus in eine der Vielzahl von Bereichen der Datenspeichereinheit kollektiv mit einer einzelnen Schreibeoperation schreibt, in einer Weise, dass der Empfangsstatus am Ende der Empfangsdaten geschrieben wird, und, dass der Empfangsstatus am Ende der einen der Vielzahl von Bereichen lokalisiert ist; wobei
der Empfangsstatus anzeigt, dass die Empfangsdaten in den einen der Vielzahl von Bereichen geschrieben ist.

2. Speichersteuervorrichtung nach Anspruch 1, **dadurch gekennzeichnet, dass**
die Empfangsdaten erste Daten und zweite Daten beinhalten, und
die Datenschreibeinheit (21b) die ersten Daten, die zweiten Daten und den Empfangsstatus in der einen der Vielzahl von Bereichen (25) kollektiv mit einer einzelnen Schreibeoperation schreibt, in einer Weise, dass der Empfangsstatus am Ende der Empfangsdaten geschrieben ist, und, dass der Empfangsstatus am Ende des einen Bereichs lokalisiert ist und die ersten Daten und die zweiten Daten direkt vor dem Empfangsstatus in der Reihenfolge lokalisiert sind.

3. Speichersteuervorrichtung nach Anspruch 2, **dadurch gekennzeichnet, dass**
die ersten Daten eingebettete Daten sind, die eine Steuerinformation einer Software anzeigen, und
die zweiten Daten Applikationsdaten sind.

4. Speichersteuervorrichtung nach Anspruch 1 und 2, **dadurch gekennzeichnet, dass**
wenn es einen Fehler in den Empfangsdaten gibt, die Datenschreibeinheit (21b) ein Fehlerkennzeichen anstelle des Empfangsstatus schreibt.

5. Speichersteuervorrichtung nach Anspruch 1, 2 und 4, **gekennzeichnet durch** ferner umfassend:
eine Daten-Aktualisierungseinheit (74), welche, wenn die Empfangsdaten, die in der Datenspeichereinheit (22a) gespeichert sind, aktualisiert werden, eine Schreibenstartadresse der Empfangsdaten auf ein ganzzahliges Vielfaches einer Speicherausrichtung, die im Vorhinein bestimmt ist, oder eine Blockgröße, die im Vorhinein bestimmt ist, setzt.

6. Speichersteuerverfahren des Kommunizierens mit einer Übertragungsseiten-Terminalvorrichtung (10) und Speichern von Empfangsdaten und einem Empfangsstatus, der einen Status der Empfangsdaten anzeigt, in einer Datenspeichereinheit (22a), welche eine Vielzahl von Bereichen (25) beinhaltet, unterteilt in eine vorbestimmte Spanne, wobei das Speichersteuerverfahren umfasst:
Empfangen von Daten von der Übertragungsseiten-Terminalvorrichtung und Erzeugen des Empfangsstatus aus den Empfangsdaten; und
Schreiben, wenn die Empfangsdaten von der Übertragungsseiten-Terminalvorrichtung empfangen werden, der Empfangsdaten und des Empfangsstatus in eine der Vielzahl von Bereichen der Datenspeichereinheit (22b) kollektiv mit einer einzelnen Schreibenoperation, in einer Weise, dass der Empfangsstatus am Ende der Empfangsdaten geschrieben ist, und, dass der Empfangsstatus an einem Ende der einen der Vielzahl von Bereichen lokalisiert ist; wobei
der Empfangsstatus anzeigt, dass die Daten in dem einen der Vielzahl von Bereichen geschrieben sind.

7. Computer-lesbares Medium, welches ein Computerprogramm speichert, welches, wenn es auf einem Computer ausgeführt wird, verursacht, dass der Computer das Verfahren nach Anspruch 6 ausführt.

8. Informationsverarbeitungsvorrichtung, umfassend:
die Speichersteuervorrichtung nach Anspruch 1; wobei
eine Kommunikationseinheit (21a) Übertragung und Empfang von Informationen steuert;
die Datenspeichereinheit (22a) die Informationen speichert; und
die Datenschreibeeinheit (21b), wenn die Information über die Kommunikationseinheit empfangen wird, die Information in die Datenspeichereinheit durch Anfügen von Empfangsstatusinformation, welche einen Empfangsstatus der Information anzeigt, an ein Ende der Information schreibt.

## Revendications

1. Appareil de contrôle de stockage qui communique avec un appareil terminal côté transmission (10) et mémorise des données de réception et un état de réception indiquant un état des données de réception, l'appareil de contrôle de stockage comportant :
une unité de stockage de données (22a) qui comprend une pluralité de zones (25) divisées en une plage prédéterminée ; et
une unité de communication (21a) qui reçoit les données depuis l'appareil terminal côté transmission et crée le statut de réception à partir des données de réception ;
**caractérisé par**
une unité d'écriture de données (21b) qui écrit, lorsque les données de réception sont reçues depuis l'appareil terminal côté de transmission, les données de réception et le statut de réception dans l'une de la pluralité de zones de l'unité de stockage de données collectivement avec une unique opération d'écriture, de telle sorte que le statut de réception est écrit à la fin des données de réception, et que le statut de réception est situé à une extrémité de l'une de la pluralité de zones ; dans lequel
le statut de réception indique que les données de réception sont écrites dans l'une de la pluralité de zones.

2. Appareil de contrôle de stockage selon la revendication 1, **caractérisé en ce que**
les données de réception comprennent des premières données et des secondes données, et
l'unité d'écriture de données (21b) écrit les premières données, les secondes données, et le statut de réception dans l'une de la pluralité de zones (25) collectivement avec une unique opération d'écriture, de telle sorte que l'état de réception est écrit à la fin des données de réception, et que l'état de réception est situé à la fin de la première zone et les premières données et les secondes données sont situées devant l'état de réception dans l'ordre.

3. Appareil de contrôle de stockage selon la revendication 2, **caractérisé en ce que**
les premières données sont des données enfouies indiquant une information de contrôle d'un logiciel, et
les secondes données sont des données d'application.

4. Appareil de contrôle de stockage selon les revendications 1 et 2, **caractérisé en ce que**
lorsqu'il y a une erreur dans les données de réception, l'unité d'écriture de données (21b) écrit un drapeau d'erreur au lieu de l'état de réception.

5. Appareil de contrôle de stockage selon les revendications 1, 2, et 4, **caractérisé en ce qu'**il comporte en outre :
une unité de mise à jour de données (74) qui fixe, lors de la mise à jour des données de réception mémorisées dans l'unité de stockage de données (22a), une adresse de départ d'écriture des données de réception à un entier multiple d'un alignement de mémoire déterminé à l'avance ou d'une taille de bloc déterminé à l'avance.

6. Procédé de contrôle de stockage pour communiquer avec un appareil terminal côté transmission (10) et mémorisant des données de réception et un état de réception indiquant un état des données de réception dans une unité de stockage de données (22a) qui comprend une pluralité de zones (25) divisées en une plage prédéterminée, le procédé de contrôle de stockage comportant :
la réception des données à partir de l'appareil terminal côté transmission et la création de l'état de réception à partir des données de réception ; et
l'écriture, lorsque les données de réception sont reçues depuis l'appareil terminal côté transmission, des données de réception et de l'état de réception dans l'une de la pluralité de zones de l'unité de stockage de données (22b) collectivement avec une opération d'écriture unique, de telle sorte que l'étape de réception est écrite à l'extrémité des données de réception, et que l'état de réception est situé à une extrémité de l'une de la pluralité de zones ; dans lequel
l'état de réception indique que les données sont écrites dans l'une de la pluralité de zones.

7. Support d'enregistrement pouvant être lu par un ordinateur qui mémorise un programme informatique, qui, lorsqu'il est exécuté sur un ordinateur, amène l'ordinateur à exécuter le procédé selon la revendication 6.

8. Appareil de traitement d'information comportant :
l'appareil de contrôle de stockage selon la revendication 1 ; dans lequel
une unité de communication (21a) contrôle la transmission et la réception de l'information ;
l'unité de mémorisation de données (22a) mémorise l'information ; et
l'unité d'écriture des données (21b) écrit, lorsque l'information est reçue par l'intermédiaire de l'unité de communication, l'information dans l'unité de stockage de données en joignant une information d'état de réception indiquant un état de réception de l'information à la fin de l'information.
